# EUROPÄISCHE PATENTANMELDUNG

(11) **EP 2 211 431 A1**
(43) Veröffentlichungstag der Anmeldung: **28.07.2010**
(21) Anmeldenummer: 09151148.5
(22) Anmeldetag: 22.01.2009
(51) Int. Cl.: H01S 5/183, H01S 5/327

(54) **Bragg-Spiegel mit Übergitter zur Kompensation einer Gitterfehlanpassung**

(71) Anmelder: Universität Bremen, 28359 Bremen (DE)
(72) Erfinder: Kruse, Carsten, Dr., 28209 Bremen (DE); Pacuski, Wojciech, Dr., 28213 Bremen (DE); Hommel, Detlef, Prof. Dr. habil, 28309 Bremen (DE)
(74) Vertreter: Tappe, Udo

(57) **Zusammenfassung**

Die Erfindung betrifft ein Halbleiterelement, insbesondere als Bauelement für einen Bragg-Spiegel (19), mit einem Lagenpaar (11) mit einer ersten Lage (12) mit einem ersten Brechungsindex und einer ersten Gitterkonstante, einer zweiten Lage (13) mit einem von dem ersten Brechungsindex abweichenden zweiten Brechungsindex und mit einer zu der ersten Gitterkonstante zum Ausbilden einer guten Kristallstruktur mindestens ähnlichen zweiten Gitterkonstante. Zum Erweitern der Auswahlmöglichkeiten geeigneter Materialkombinationen für ein Lagenpaar (11) mit einer ersten Lage (12) und einer zweiten Lage (13) ist das Halbleiterelement dadurch gekennzeichnet, dass die erste Lage (12) als ein Übergitter (23) aus periodisch sich wiederholenden, unterschiedlichen und aufeinander aufgebrachten Schichten (25,26,27,28) ausgebildet ist.
Als Materialien für den Einsatz im roten Spektralbereich kommen insbesondere MGSe (25), ZnTe (13,22,26,28) und MGTe (27) zum Einsatz.

## Beschreibung

Die Erfindung betrifft ein Halbleiterelement, insbesondere als Bauelement für einen Bragg-Spiegel, mit einem Lagenpaar mit einer ersten Lage mit einem ersten Brechungsindex und einer ersten Gitterkonstante, einer zweiten Lage mit einem von dem ersten Brechungsindex abweichenden zweiten Brechungsindex und mit einer zu der ersten Gitterkonstante zum Ausbilden einer guten Kristallstruktur mindestens ähnlichen zweiten Gitterkonstante. Weiter betrifft die Erfindung einen Bragg-Spiegel sowie einen Oberflächenemitter, insbesondere Vertikalresonator, Mikrokavität, Mikrosäule, mit einem Bragg-Spiegel.

Halbleiterelemente der vorgenannten Art werden beispielsweise als ein Bauelement für einen Bragg-Spiegel oder Bragg-Reflektor verwendet. Das grundlegende Prinzip eines Bragg-Spiegels basiert darauf, zwei Materialien mit unterschiedlichem Brechungsindex aufeinander anzuordnen. Derartige Lagenpaare werden mehrfach aufeinander angeordnet, wodurch eine Mehrlagenstruktur ausgebildet wird. Hierbei wiederholen sich die unterschiedlichen Materialien periodisch. Mittels einer solchen Lagenstruktur sind Spiegel herstellbar, deren Reflektivität bei einer bestimmten Wellenlänge bei bis zu 99 % oder deutlich über 99 % liegt. Derartige Bragg-Spiegel weisen nahezu keine Absorption auf, wobei die hohe Reflektivität durch Mehrfachinterferenzen erreichbar ist.

Damit weisen Bragg-Spiegel eine deutlich höhere Refektivität als beispielsweise Aluminium- oder Silberspiegel auf.

Insbesondere für optoelektronische Bauelemente werden für die erste Lage und die zweite Lage Halbleitermaterialien verwendet. Hierbei weist das Halbleitermaterial der ersten Lage einen ersten Brechungsindex auf, der hinreichend von dem zweiten Brechungsindex der zweiten Lage abweicht, so dass bei einer Anordnung der ersten Lage und der zweiten Lage als ein Lagenpaar eine Bragg-Reflexion auslösbar ist.

Eine Voraussetzung zur Herstellung von Bragg-Spiegeln mit einer hohen Qualität, insbesondere einer hohen Reflektivität, einer hohen Lebensdauer und/oder einer hohen Effizienz des späteren Bauelementes, ist eine gute Kristallstruktur über das Lagenpaar bzw. die Mehrlagenstruktur. Insbesondere im Bereich des Überganges von der ersten Lage zu der zweiten Lage und/oder von einem Lagenpaar zu einem auf diesem Lagenpaar angeordneten weiteren Lagenpaar ist eine gute Kristallstruktur notwendig. Hierbei ist eine gute Kristallstruktur gegeben, wenn die Kristallstruktur eine hinreichende optische Qualität aufweist, so dass eine beispielsweise für einen Bragg-Spiegel ausreichend hohe Reflektivität, insbesondere von mehr als 99 %, für eine vorgegebene Wellenlänge und/oder einen Wellenlängenbereich gewährleistet ist. Eine gute Kristallgitterstruktur ist vorzugsweise möglichst regelmäßig und/oder gitterfehlerfrei ausgebildet. Hierbei kann es für eine gute Kristallstruktur ausreichend sein, dass die Anzahl und/oder die Verteilung von gegebenenfalls vorhandenen Gitterfehlern in der Kristallstruktur derart ausgebildet sind, dass hierdurch die optische Qualität der Kristallstruktur beispielsweise in einem entsprechenden Bragg-Spiegel nicht oder zumindest nicht wesentlich beeinträchtigt wird.

Hinsichtlich des Ausbildens einer guten Kristallstruktur ist Vorraussetzung, dass das Material für die erste Lage und die zweite Lage derart gewählt wird, dass die erste Gitterkonstante der ersten Lage mindestens ähnlich zu der zweiten Gitterkonstanten der zweiten Lage ist. Auf diese Weise ist die Entstehung von Gitterfehlern hinreichend vermeidbar bzw. reduzierbar.

Nachteilig ist, dass die Voraussetzung eines voneinander abweichenden Brechungsindex hinsichtlich der Materialien der ersten Lage und der zweiten Lage einerseits und die Anforderung an die zumindest ähnlichen Gitterkonstanten der ersten Lage und der zweiten Lage die Auswahl geeigneter Materialkombinationen sehr stark einschränkt.

So stehen beispielsweise bisher keine binären Materialien zur Verfügung, die im Vergleich zu ZnTe einen zum Ausbilden eines Bragg-Spiegels hinreichend abweichenden Brechungsindex und zugleich eine zu ZnTe mindestens ähnliche Gitterkonstante aufweisen. ZnTe weist einen sehr hohen Brechungsindex auf und bietet somit aufgrund seiner Bandlücke grundsätzlich die Möglichkeit, einen Bragg-Spiegel mit einer maximalen Reflektivität im Wellenlängenbereich zwischen 550 nm und 750 nm, insbesondere für eine maximale Reflektivität bei 639 nm, herzustellen. Somit sind auf der Basis von ZnTe Bragg-Spiegel oder Oberflächenemitter denkbar, die insbesondere im Bereich des orangen Lichtes einsetzbar sind. Ein Wellenlängenbereich, der bislang beispielsweise im Bereich der Optoelektronik praktisch nicht nutzbar ist.

Bislang ist lediglich die Herstellung von Legierungen bekannt, die beispielsweise mit ZnTe zum Ausbilden eines Bragg-Spiegels genutzt werden können (vgl. "New Concept for ZnTe-Based Homoexpitaxial Light-Emitting Diodes Grown by Molecular Beam Epitaxy" A. Ueta and D. Hommel, phy. stat. sol. (a) 192, 177 (2002)).

Hierbei ist jedoch nachteilig, dass die Einstellung des richtigen Mengenverhältnisses zwischen den eingesetzten Materialien zur Herstellung der Legierung zu praktischen Schwierigkeiten und Problemen führt. Derartige Legierungen sind mit einem sehr hohen Herstellungsaufwand und erheblichen Schwierigkeiten bei der Reproduzierbarkeit verbunden. Dies führt dazu, dass Bragg-Spiegel nur für wenige bestimmte Wellenlängen und/oder Wellenlängenbereiche effektiv herstellbar sind.

Somit ist es das der Erfindung zugrunde liegende Problem, ein Halbleiterelement der eingangs genannten Art derart weiter zu entwickeln, dass die Auswahlmöglichkeit geeigneter Materialkombinationen für ein Lagenpaar mit einer ersten Lage und einer zweiten Lage erweitert wird.

Das der Erfindung zugrunde liegende Problem wird dadurch gelöst, dass die erste Lage als ein Übergitter aus periodisch sich wiederholenden, unterschiedlichen und aufeinander aufgebrachten Schichten ausgebildet ist.

Ein Übergitter ist ein künstlich hergestellter Festkörper, der aus einer Abfolge von periodisch sich wiederholenden dünnen Schichten besteht. Mittels eines solchen Übergitters aus Schichten aus unterschiedlichen Halbmaterialien ist ein künstlicher Festkörper herstellbar, der eine eigene Gitterkonstante aufweist, die sich von den Gitterkonstanten der Materialien der einzelnen Schichten unterscheidet. Die Herstellung des Übergitters erfolgt insbesondere über Molekularstrahlepitaxie (MBE), chemische Gasphasenabscheidung (CVD) oder Gasphasenepitaxie (MOVPE). Auf diese Weise ist eine gute Kristallstruktur des Lagenpaares realisierbar. Weiter ergibt sich aufgrund der Ausgestaltung der ersten Lage als ein Übergitter eine erheblich größere Auswahl an geeigneten Materialkombinationen zum Herstellen eines Halbleiterelementes. Vorzugsweise ist die zweite Lage ebenfalls als ein Übergitter aus periodisch sich wiederholenden, unterschiedlichen und aufeinander aufgebrachten Schichten ausgebildet. Insbesondere sind die Schichten des Übergitters der zweiten Lage aus mindestens teilweise anderen Materialien gebildet, als die Schichten des Übergitters der ersten Lage. Hierdurch kann sich eine noch größere Auswahl an geeigneten Materialkombinationen für das Lagenpaar des Halbleiterelementes ergeben. Weiter ist von Vorteil, dass das Halbleiterelement bei Raumtemperatur, insbesondere als Bauelement für einen Bragg-Spiegel, einsetzbar ist.

Vorzugsweise ist die erste Gitterkonstante der ersten Lage mittels einer geeigneten Konfiguration des Übergitters, insbesondere aufgrund geeigneter Schichtdicken und verwendeter Materialien, an die zweite Gitterkonstante der zweiten Lage angepasst. Aufgrund einer geeigneten Auswahl der für die einzelnen Schichten des Übergitters verwendeten Materialien ist die erste Gitterkonstante der ersten Lage an die zweite Gitterkonstante der zweiten Lage anpassbar. Die für die einzelnen Schichten des Übergitters ausgewählten Materialien sind hierbei vorzugsweise vom jeweiligen Brechungsindex, der jeweiligen Bandlücke und der jeweiligen Gitterkonstante abhängig. Hierbei gilt hinsichtlich des Verhältnisses zwischen Brechungsindex und Bandlücke, dass der Brechungsindex umso größer ist, je kleiner die Bandlücke ist. Demnach ist die Bandlücke umso größer je kleiner der Brechungsindex ist. Des Weiteren wird für jede einzelne Schicht eine zum Realisieren einer geeigneten ersten Gitterkonstante individuelle Schichtdicke realisiert.

Nach einer Weiterbildung bilden die unterschiedlichen aufeinander aufgebrachten Schichten der ersten Lage eine Schichtfolge und mehrere aufeinander angeordnete Schichtfolgen das Übergitter, wobei die Schichtfolge mindestens eine erste Schicht und eine zweite Schicht aufweist. Somit besteht das Übergitter aus mehreren Schichtfolgen, die wiederum lediglich zwei Schichten aufweisen. Damit besteht die erste Lage aus nur zwei unterschiedlichen Materialien. Dies vereinfacht die Herstellung des Halbleiterelementes und begünstigt somit eine kostengünstige Herstellung von beispielsweise einem Bragg-Spiegel und/oder einem Oberflächenemitter mit einem erfindungsgemäßen Halbleiterelement.

Vorzugsweise ist zwischen den Schichten eine Trennschicht angeordnet, wobei insbesondere die zweite Lage aus einem ersten Lagenmaterial und die Trennschicht aus dem ersten Lagenmaterial besteht. Mittels einer derartigen Trennschicht kann die Realisierung einer möglichst guten Kristallstruktur begünstigt werden. Wenn beispielsweise die erste Schicht und die zweite Schicht deutlich voneinander abweichende Gitterkonstanten aufweisen, können sich bei einer direkten Anordnung der Schichten übereinander Gitterfehler ausbilden. Hierbei besteht jedoch die Gefahr, dass aufgrund solcher Gitterfehler beispielsweise die Reflektivität eines Bragg-Spiegels bzw. Die Lebensdauer und/oder die Effizienz des späteren Bauelementes vermindert wird. Mittels einer Trennschicht aus einem geeigneten Material oder einer geeigneten Materialkombination sind Schichten mit unterschiedlichen Gitterkonstanten in einer Schichtfolge derart kombinierbar, dass ansonsten bei einer unmittelbaren Anordnung der Schichten aufeinander auftretende Gitterfehler vermieden und/oder hinreichend reduziert werden. Vorzugsweise ist die Trennschicht möglichst dünn ausgestaltet. So kann die Trennschicht beispielsweise dünner als eine Monolage sein. Wenn die Trennschicht aus dem ersten Lagenmaterial der zweiten Lage besteht, wird die Anpassung der ersten Gitterkonstante der ersten Lage bzw. des Übergitters an die zweite Gitterkonstante der zweiten Lage begünstigt.

Entsprechend einer Weiterbildung weisen ein erstes Schichtmaterial der ersten Schicht eine erste Schichtgitterkonstante und einen ersten Schichtbrechungsindex, und ein zweites Schichtmaterial der zweiten Schicht eine von der ersten Schichtgitterkonstante abweichende zweite Schichtgitterkonstante und einen zu dem ersten Schichtbrechungsindex mindestens ähnlichen zweiten Schichtbrechungsindex auf, und die erste Gitterkonstante der ersten Lage und/oder die zweite Gitterkonstante der zweiten Lage liegt zwischen der ersten Schichtgitterkonstante und der zweiten Schichtgitterkonstante. Demnach unterscheiden sich die erste Schichtgitterkonstante und die zweite Schichtgitterkonstante von der ersten Gitterkonstante der ersten Lage und/oder der zweiten Gitterkonstante der zweiten Lage derart, dass die erste Gitterkonstante und/oder die zweite Gitterkonstante zwischen der ersten Schichtgitterkonstante und der zweiten Schichtgitterkonstante liegt. Somit ergibt sich die erste Gitterkonstante der ersten Lage als ein Mittelwert zwischen der ersten Schichtgitterkonstante und der zweiten Schichtgitterkonstante. Aufgrund einer geeigneten Auswahl der Schichtdicken der ersten Schicht und der zweiten Schicht ist die erste Gitterkonstante derart festlegbar, dass diese der zweiten Gitterkonstante mindestens ähnlich, insbesondere gleich, ist. Hierdurch ist eine hinreichend gute Kristallstruktur des Lagenpaares realisierbar. Für die Ausbildung der Abfolge von sich periodisch wiederholenden aufeinander aufgebrachten Schichten zum Realisieren des Übergitters werden insgesamt lediglich drei unterschiedliche Materialien verwendet. Wenn zudem die Trennschicht innerhalb des Übergitters und die zweite Lage aus dem gleichen Material bestehen, werden auch für das Lagenpaar nur diese drei unterschiedliche Materialien benötigt.

Nach einer weiteren Ausführungsform sind die erste Lage und die zweite Lage, insbesondere um mindestens eine dezimale Größenordnung, dicker als die Schichten des Übergitters. Bei einer Verwendung des Halbleiterelementes bzw. des Lagenpaares, beispielsweise als ein Bauelement für einen Bragg-Spiegel, bestimmt sich die Dicke der ersten Lage und der zweiten Lage in Abhängigkeit von einer Wellenlänge λ mittels der Gleichung d = λ/(4n), wobei d die Lagendicke und n für den ersten Brechungsindex der ersten Lage oder für den zweiten Brechungsindex der zweiten Lage steht.

Vorzugsweise weisen die Schichten des Übergitters Schichtdicken von weniger als einigen hundert Monolagen, insbesondere weniger als 100 und/oder weniger als 10 Monolagen, vorzugsweise weniger als eine Monolage, auf. Die Herstellung solcher Übergitter ist beispielsweise mittels Molekularstrahlepitaxie (MBE), chemischer Gasphasenabscheidung (CVD) oder Gasphasenepitaxie (MOVPE) bereits seit langem bewährt.

Nach einer Weiterbildung ist das erste Schichtmaterial, das zweite Schichtmaterial und/oder das erste Lagenmaterial als ein binäres Material, vorzugsweise das erste Schichtmaterilal als MgSe, das zweite Schichtmaterial als MgTe und das erste Lagenmaterial als ZnTe, ausgebildet. Vorzugsweise besteht die Trennschicht ebenfalls aus einem binären Material, insbesondere ZnTe. Bei dem binären Material handelt es sich insbesondere um ein Halbleitermaterial. Somit ist ein Halbleiterelement bzw. ein Lagenpaar herstellbar, wobei die erste Lage aus ZnTe gebildet ist und die zweite Lage durch eine Schichtabfolge aus MgSe, ZnTe und MgTe realisierbar ist. Hierdurch ist die erste Gitterkonstante der ersten Lage an die zweite Gitterkonstante, insbesondere der Gitterkonstante von ZnTe, hinreichend anpassbar, so dass eine weitgehend regelmäßige, gitterfehlerfreie Kristallstruktur realisierbar ist. Neben dem Einsatz von binären Materialien sind auch weitere Materialen, insbesondere Halbleitermaterialien, verwendbar. Hierzu gehören beispielsweise ternäre, quaternäre oder höhere Materialkombinationen.

Vorzugsweise weist das Halbleiterelement bzw. das Lagenpaar einen monolithischen Aufbau auf. Hierdurch ist eine besonders hohe optische Qualität des Halbleiterelementes realisierbar. Dies ermöglicht beispielsweise die Herstellung eines Bragg-Spiegels mit einer sehr hohen Reflektivität für eine Wellenlänge und/oder einen Wellenlängenbereich von deutlich über 99 %.

Gemäß einer auch eigenständig und unabhängig von der Erfindung anwendbaren Ausführung weist ein Bragg-Spiegel eine Anzahl von mehreren aufeinander aufgebrachten erfindungsgemäßen Halbleiterelementen auf. Aufgrund der deutlich größeren Auswahl an geeigneten Materialkombinationen hinsichtlich der Materialwahl für die erste Lage und/oder die zweite Lage sind somit Bragg-Spiegel realisierbar, die für eine Wellenlänge und/oder für einen Wellenlängenbereich eine maximale Reflektivität aufweisen, die bzw. der bisher für Bragg-Spiegel, insbesondere auf Basis von ZnTe, nicht nutzbar war. Hierbei ist eine Reflektivität von deutlich über 99 % erreichbar. Damit erschließen sich für die Verwendung von Bragg-Spiegeln neue Einsatzgebiete, wie beispielsweise in der Optoelektronik. So sind beispielsweise Bragg-Spiegel, Mikrolaser oder Oberflächenemitter realisierbar, die im Bereich von orangem Licht arbeiten. Hierdurch lässt sich beispielsweise die Übertragungsrate im Bereich der optischen Datenübertragung einfach und deutlich erhöhen.

Nach einer Weiterbildung des Bragg-Spiegels ist mittels einer geeigneten Auswahl der Anzahl der Schichtfolgen im Übergitter und/oder der Anzahl der Lagenpaare eine Wellenlänge und/oder ein Wellenlängenbereich einer maximalen Reflektivität, insbesondere im Bereich zwischen 550 nm und 750 nm, bestimmt. So kann die Anzahl der aufeinander aufgebrachten Lagenpaare beispielsweise im Bereich zwischen 10 und 100 Lagenpaaren, insbesondere bei 15 Lagenpaaren, liegen. Die Anzahl der aufeinander aufgebrachten Schichtfolgen im Übergitter der ersten Lage kann im Bereich von beispielsweise 10 bis 100, insbesondere bei 18 Schichtfolgen, liegen. Der Wellenlängenbereich der maximalen Reflektivität liegt insbesondere im Bereich zwischen 550 nm und 700 nm, vorzugsweise liegt die Wellenlänge der maximalen Reflektivität bei 639 nm.

Vorzugsweise ist mittels einer geeigneten Auswahl der Schichtdicke mindestens einer Schicht der Schichtfolge und/oder der Lagendicke der ersten Lage und/oder der zweiten Lage des Lagenpaares eine Wellenlänge und/oder ein Wellenlängenbereich einer maximalen Reflektivität, insbesondere im Bereich zwischen 550 nm und 750 nm, bestimmt. So kann die Schichtdicke einer Schicht der Schichtfolge im Bereich zwischen 0,5 nm bis 2 nm liegen, während die Lagendicke im Bereich zwischen 10 nm und 100 nm liegen kann. Weiter ist die Wellenlänge und/oder der Wellenlängenbereich der maximalen Reflektivität mittels dünnerer Schichten ins grüne Licht, also in Richtung auf 550 nm, und mittels dickerer Schichten ins rote Licht, also in Richtung auf 750 nm, verschiebbar. Insbesondere liegt der Wellenlängenbereich der maximalen Reflektivität im Bereich zwischen 550 nm und 700 nm, vorzugsweise liegt die Wellenlänge der maximalen Reflektivität bei 639 nm.

Nach einer weiteren Ausführungsform ergibt sich die Lagendicke der ersten Lage und der zweiten Lage mittels der Gleichung d = λ/(4n), wobei d die Lagendicke, λ eine vorgegebene Wellenlänge und n der erste Brechungsindex für die erste Lage oder der zweite Brechungsindex für die zweite Lage ist. Hierdurch ergibt sich die Lagendicke auf die für einen Bragg-Spiegel bewährte Weise.

Nach einer auch eigenständig und unabhängig von der Erfindung anwendbaren Weiterbildung weist ein Oberflächenermitter, insbesondere Vertikalresonator, Mikrokavität, Mikrosäule, mit einem erfindungsgemäßen Bragg-Spiegel vorzugsweise mindestens einen Quantenfilm und/oder Quantenpunkt auf. Hierbei kann der Quantenfilm oder Quantenpunkt aus einem optisch aktiven Medium, insbesondere ZnCdTe, ausgebildet sein. Vorzugsweise enthält das optisch aktive Medium magnetische Anteile, insbesondere Mn-lonen. Somit sind Strukturen, beispielsweise für die Spintronik, bei Raumtemperatur realisierbar. Damit ergeben sich neue Einsatzgebiete, wie beispielsweise auf der Basis der Manipulation einzelner Elektronenspins im Bereich der Quanteninformationsverarbeitung und/oder im Bau von Halbleiterlasern im sichtbaren Spektrum.

Von besonderem Vorteil ist die Verwendung eines erfindungsgemäßen Halbleiterelementes und/oder eines erfindungsgemäßen Bragg-Spiegels und/oder eines erfindungsgemäßen Oberflächenermitters für eine Anwendung in der Optoelektronik, Quanteninformationsverarbeitung oder dergleichen.

Nachfolgend wird das erfindungsgemäße Halbleiterelement anhand der folgenden Figuren näher erläutert. Es zeigen:
- Fig. 1: ein erfindungsgemäßes Halbleiterelement in einer geschnittenen Seitendarstellung,
- Fig. 2: eine Folge von aufeinander aufgebrachten erfindungsgemäßen Halbleiterelementen gemäß Fig. 1,
- Fig. 3: einen Bragg-Spiegel mit einer Abfolge von aufeinander aufgebrachten erfindungsgemäßen Halbleiterelementen,
- Fig. 4: eine Auftragung der Bandlücke gegen die Gitterkonstante für verschiedene Halbleitermaterialien, und
- Fig. 5: eine Auftragung der Reflektivität gegen die Wellenlänge für einen Bragg-Spiegel mit erfindungsgemäßen Halbleiterelementen.

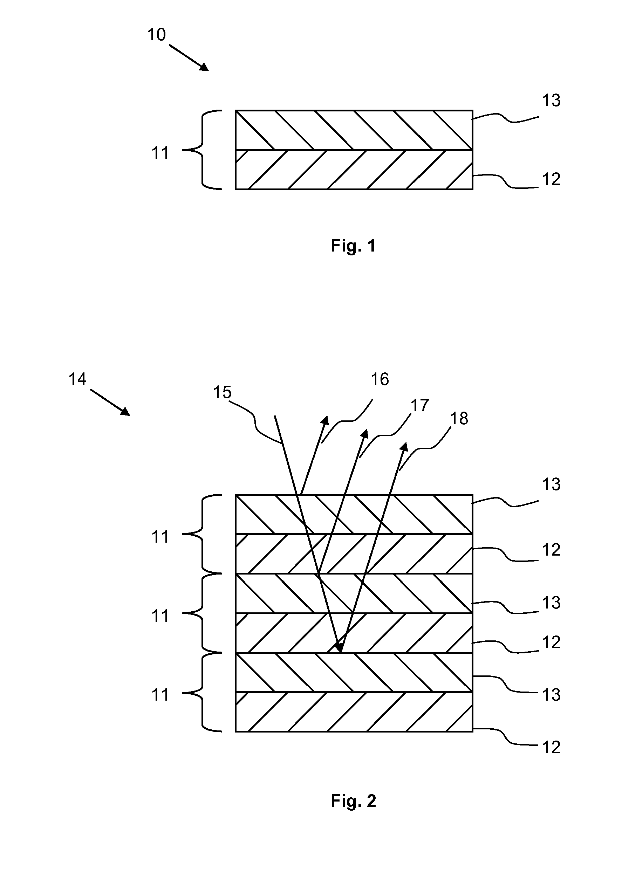

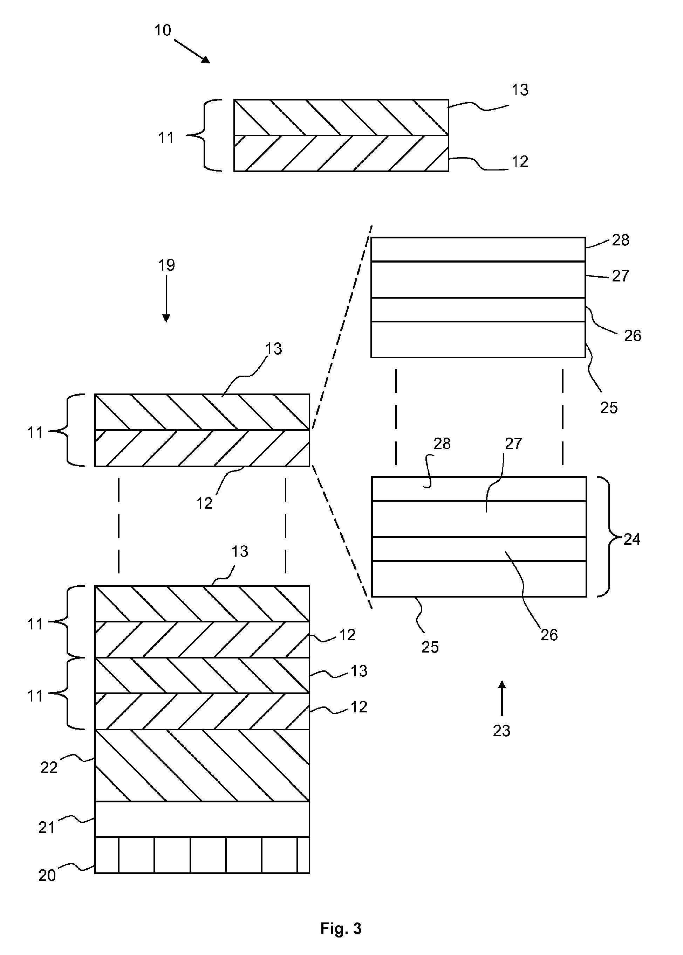

Fig. 1 zeigt ein Halbleiterelement 10 mit einem Lagenpaar 11. Hierbei besteht das Lagenpaar 11 aus einer ersten Lage 12 und einer auf der ersten Lage 12 aufgebrachten zweiten Lage 13. Die erste Lage 12 weist einen ersten Brechungsindex und eine erste Gitterkonstante und die zweite Lage 13 einen zweiten Brechungsindex und eine zweite Gitterkonstante auf. Hierbei ist der erste Brechungsindex der ersten Lage 12 geringer als der zweite Brechungsindex der zweiten Lage 13. Die erste Lage 12 ist als ein Übergitter aus einer periodisch sich wiederholenden Abfolge von vier aufeinander aufgebrachten Schichten ausgebildet. Der Aufbau des Übergitters in der ersten Lage 12 wird nachfolgend anhand der Fig. 3 näher erläutert. Die zweite Lage 13 besteht aus dem binären Halbleitermaterial ZnTe. Die erste Gitterkonstante und die zweite Gitterkonstante sind mindestens ähnlich, so dass sich für das Lagenpaar 11 eine gute Kristallstruktur ergibt. Hierbei ist unter einer guten Kristallstruktur zu verstehen, dass die optischen Eigenschaften des Lagenpaares 11 durch Fehlstellen, beispielsweise aufgrund von Gitterfehlern, nicht oder zumindest nicht wesentlich beeinträchtigt werden.

Fig. 2 zeigt eine Folge 14 von insgesamt drei aufeinander aufgebrachten Lagenpaaren 11. Die Lagenpaare 11 entsprechen hierbei dem Aufbau des Lagenpaares 11 gemäß Fig. 1. Demnach weisen die Lagenpaare 11 gemäß Fig. 2 eine erste Lage 12 und eine darauf aufgebrachte zweite Lage 13 auf. Auf einem ersten Lagenpaar 11 ist ein zweites Lagenpaar 11 und auf dem zweiten Lagenpaar 11 ein drittes Lagenpaar 11 1 aufgebracht, welche jeweils eine erste Lage 12 und eine zweite Lage 13 aufweisen.

Aufgrund des im Vergleich zu den zweiten Lagen 13 niedrigeren Brechungsindex der ersten Lagen 12 wird ein einfallender Lichtstrahl 15 an den Grenzflächen zur jeweils zweiten Lage 13 als Lichtstrahlen 16, 17 und 18 reflektiert.

Fig. 3 zeigt einen Bragg-Spiegel 19 mit einer Substratlage 20. Hierbei besteht die Substratlage 20 aus GaAs. Auf der Substratlage 20 ist eine Abstandslage 21 aufgebracht. Die Abstandslage 21 besteht aus ZnSe und ist in diesem Ausführungsbeispiel 62 nm dick. Auf diese Abstandslage 21 ist eine Pufferlage 22 aufgebracht. Die Pufferlage 22 besteht aus dem gleichen Material wie eine zweite Lage 13 eines nachfolgenden Lagenpaares 11. Als Material für die Pufferlage 22 wird demnach bei dem gezeigten Ausführungsbeispiel ZnTe verwendet. Die Pufferlage 22 ist in diesem Ausführungsbeispiel 1010 nm dick.

Auf dem auf der Pufferlage 22 aufgebrachten Lagenpaar 11 ist wiederum ein weiteres Lagenpaar 11 aufgebracht. Insgesamt sind auf der Pufferlage 22 fünfzehn aufeinander aufgebrachte Lagenpaare 11 angeordnet. Sämtliche Lagenpaare 11 entsprechen dem Aufbau eines der Lagenpaare 11 gemäß Fig. 1 und 2. Sämtliche Lagenpaare 11 weisen demnach eine erste Lage 12 und eine zweite Lage 13 auf.

Die erste Lage 12 der Lagenpaare 11 ist jeweils als ein Übergitter 23 ausgebildet. Das Übergitter 23 besteht aus einer Abfolge von aufeinander aufgebrachten Schichtfolgen 24. Bei dem gezeigten Ausführungsbeispiel sind insgesamt achtzehn Schichtfolgen 24 aufeinander aufgebracht. Jeweils eine Schichtfolge 24 weist eine erste Schicht 25, eine Trennschicht 26, eine zweite Schicht 27 und eine Trennschicht 28 auf. Die erste Schicht 25 besteht aus dem Halbleitermaterial MgSe und ist bei dem gezeigten Ausführungsbeispiel 1,4 nm dick. Die Trennschichten 26 und 28 bestehen wie die Pufferlage 22 und die zweite Lage 13 aus ZnTe und sind bei dem gezeigten Ausführungsbeispiel jeweils 0,7 nm dick. Die zweite Schicht 26 besteht aus MgTe und ist in dem Ausführungsbeispiel 0,9 nm dick. Damit ergibt sich eine Dicke der Schichtfolge 24 von 3,7 nm und eine Lagendicke der ersten Lage 12 von 66,6 nm. Die zweite Lage 13 weist in diesem Ausführungsbeispiel eine Dicke von 53 nm auf.

Insgesamt ergibt sich für den Bragg-Spiegel 19 ein monolithischer Aufbau, der eine hinreichend gute Kristallstruktur aufweist. Es wird eine Reflektivität von weit über 99 % für die Wellenlänge λ = 639 nm erreicht. Darüber hinaus ergibt sich in einem Wellenlängenbereich von etwa ±36 nm um die Wellenlänge der maximalen Reflektivität eine Reflektivität von mindestens 90 %.

Die Lagendicke der ersten Lage 12 und der zweiten Lage 13, die Wellenlänge λ und der jeweilige Brechungsindex n der ersten Lage 12 bzw. der zweiten Lage 13 stehen über die Gleichung d = λ/(4n) miteinander in Beziehung. Hierdurch ist es möglich in Ergänzung zum gezeigten Ausführungsbeispiel weitere Bragg-Spiegel herzustellen, die vom grundsätzlichen Aufbau dem Bragg-Spiegel 19 entsprechen, jedoch hiervon abweichende Lagendicken und/oder Schichtdicken aufweisen. Beispielsweise können die Wellenlänge und/oder der Wellenlängenbereich der maximalen Reflekitivität aufgrund im Vergleich zum Ausführungsbeispiel dünner ausgebildeter Schichten 25, 26, 27 und/oder 28 in Richtung des grünen Lichtes verschoben sein. Andererseits können die Wellenlänge und/oder der Wellenlängenbereich der maximalen Reflekitivität aufgrund im Vergleich zum Ausführungsbeispiel dicker ausgebildeter Schichten 25, 26, 27 und/oder 28 in Richtung des roten Lichtes verschoben sein.

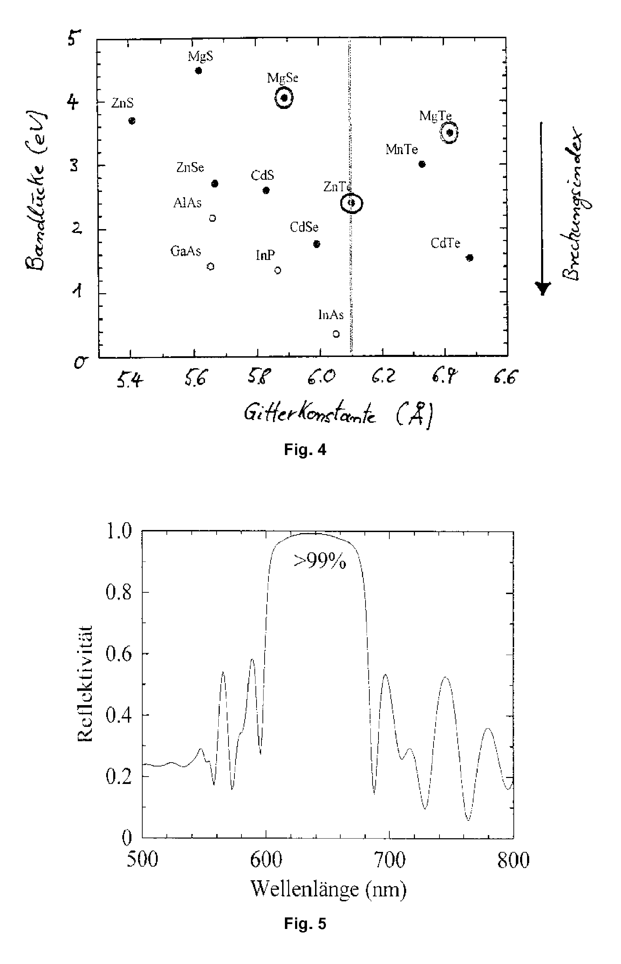

Fig. 4 zeigt ein Diagramm für verschiedene Halbleitermaterialen. Hierbei ist die Bandlücke bzw. Energielücke in eV auf der Ordinate aufgetragen, während auf der Abszisse die Gitterkonstante in Angström aufgetragen ist. Zum Herstellen eines Bragg-Spiegels werden eine erste Lage und eine zweite Lage mit unterschiedlichen Brechungsindizes aufeinander aufgebracht. Damit jedoch hinreichende optische Eigenschaften des Bragg-Spiegels aufgrund einer ausreichend guten Kristallstruktur gewährleisten sind, müssen die beiden Materialien mindestens ähnliche Gitterkonstanten aufweisen. Wie der Fig. 4 zu entnehmen ist, werden diese Vorraussetzungen nur von wenigen Halbleitermaterialien erfüllt.

So weisen beispielsweise GaAs und AlAs eine hinreichend ähnliche Gitterkonstante und zugleich zum Ausbilden eines Bragg-Spiegels ausreichend voneinander abweichende Brechungsindizes auf. Für viele Halbleitermaterialien, wie beispielsweise ZnTe, stehen jedoch unmittelbar keine geeigneten Materialen zum Herstellen eines Bragg-Spiegels zur Verfügung.

Mit MgSe steht im Vergleich zu ZnTe ein Material zur Verfügung, welches einen deutlich niedrigeren Brechungsindex bzw. eine höhere Energielücke oder Bandlücke, jedoch eine deutlich kleinere Gitterkonstante als ZnTe aufweist. Daher würde eine direkte Kombination von ZnTe mit MgSe die optischen Eigenschaften aufgrund von Gitterfehlern zu sehr beeinträchtigen. Andererseits weist MgTe ebenfalls eine im Vergleich zu ZnTe deutlich niedrigeren Brechungsindex bzw. eine höhere Energielücke oder Bandlücke auf, wobei die Gitterkonstante von MgTe jedoch deutlich größer ist als die von ZnTe. Somit würde auch eine direkte Kombination von ZnTe mit MgTe die optischen Eigenschaften eines hieraus hergestellten Bragg-Spiegels zu sehr beeinträchtigen.

Jedoch ergibt sich aufgrund einer Kombination von MgSe und MgTe in der Gestalt eines Übergitters mit sehr dünnen aufeinander aufgebrachten Schichten von MgSe und MgTe für das Übergitter bzw. die erste Lage eine Gitterkonstante, die zwischen den Materialien der ersten Schicht und der zweiten Schicht liegt. Es bildet sich also eine resultierende Gitterkonstante für das Übergitter bzw. die erste Lage. Diese erste Gitterkonstante der ersten Lage ist zu der zweiten Gitterkonstante hinreichend ähnlich.

Um mögliche Gitterfehler im Übergangsbereich zwischen der ersten Schicht und der zweiten Schicht für eine gute Kristallstruktur ausreichend zu vermeiden, ist in dem hier gezeigten Ausführungsbeispiel eine Trennschicht vorgesehen. Diese Trennschicht aus ZnTe bewirkt innerhalb des Übergitters, dass die Anzahl von Fehlstellen ausreichend vermindert wird und die optischen Eigenschaften aufgrund der Kombination der hinsichtlich der Gitterkonstante unterschiedlichen Schichten aus MgTe und MgSe somit zumindest im Wesentlichen nicht beeinträchtigt werden. Diese Trennschicht ist aber nicht zwingend erforderlich.

Damit sind Bragg-Spielgel realisierbar, die in einem bisher praktisch nicht nutzbaren Wellenlängenbereich von etwa 550 nm bis 750 nm einsetzbar sind.

Fig. 5 zeigt ein Diagramm für einen erfindungsgemäßen Bragg-Spiegel, der beispielsweise gemäß dem Bragg-Spiegel 28 nach Fig. 3 aufgebaut ist. Ein derartiger Bragg-Spiegel zeigt in einem Wellenlängenbereich von etwa 620 nm bis etwa 680 nm eine sehr hohe Reflektivität von deutlich über 99 %. Damit sind beispielsweise Mikrolaser und/oder Oberflächenemitter realisierbar, die eine hohe Abstrahlung über einen sehr breiten Wellenlängenbereich gewährleisten.

### Bezugszeichenliste:

- 10: Halbleiterelement
- 11: Lagenpaar
- 12: erste Lage
- 13: zweite Lage
- 14: Folge
- 15: einfallender Lichtstrahl
- 16: reflektierter Lichtstrahl
- 17: reflektierter Lichtstrahl
- 18: reflektierter Lichtstrahl
- 19: Bragg-Spiegel
- 20: Substratlage
- 21: Abstandslage
- 22: Pufferlage
- 23: Übergitter
- 24: Schichtfolge
- 25: erste Schicht
- 26: Trennschicht
- 27: zweite Schicht
- 28: Trennschicht

## Patentansprüche

1. Halbleiterelement, insbesondere als Bauelement für einen Bragg-Spiegel (19), mit einem Lagenpaar (11) mit einer ersten Lage (12) mit einem ersten Brechungsindex und einer ersten Gitterkonstante, einer zweiten Lage (13) mit einem von dem ersten Brechungsindex abweichenden zweiten Brechungsindex und mit einer zu der ersten Gitterkonstante zum Ausbilden einer guten Kristallstruktur mindestens ähnlichen zweiten Gitterkonstante, **dadurch gekennzeichnet, dass** die erste Lage (12) als ein Übergitter (23) aus periodisch sich wiederholenden, unterschiedlichen und aufeinander aufgebrachten Schichten ausgebildet ist.

2. Halbleiterelement nach Anspruch 1, **dadurch gekennzeichnet, dass** die erste Gitterkonstante der ersten Lage (12) mittels einer geeigneten Konfiguration des Übergitters (23), insbesondere aufgrund geeigneter Schichtdicken und verwendeter Materialien, an die zweite Gitterkonstante der zweiten Lage (13) angepasst ist.

3. Halbleiterelement nach Anspruch 1 oder 2, **dadurch gekennzeichnet, dass** die unterschiedlichen aufeinander aufgebrachten Schichten der ersten Lage (12) eine Schichtfolge (24) und mehrere aufeinander angeordnete Schichtfolgen (24) das Übergitter (23) bilden, wobei die Schichtfolge (24) mindestens eine erste Schicht (25) und eine zweite Schicht (27) aufweist.

4. Halbleiterelement nach einem der vorhergehenden Ansprüche, **gekennzeichnet durch** eine zwischen den Schichten angeordnete Trennschicht (26, 28), wobei vorzugsweise die zweite Lage (13) aus einem ersten Lagenmaterial und die Trennschicht (26, 28) aus dem ersten Lagenmaterial besteht.

5. Halbleiterelement nach einem der vorhergehenden Ansprüche, **dadurch gekennzeichnet, dass** ein erstes Schichtmaterial der ersten Schicht (25) eine erste Schichtgitterkonstante und einen ersten Schichtbrechungsindex, und ein zweites Schichtmaterial der zweiten Schicht (27) eine von der ersten Schichtgitterkonstante abweichende zweite Schichtgitterkonstante und einen zu dem ersten Schichtbrechungsindex mindestens ähnlichen zweiten Schichtbrechungsindex aufweisen, und die erste Gitterkonstante der ersten Lage (12) und/oder die zweite Gitterkonstante der zweiten Lage (13) zwischen der ersten Schichtgitterkonstante und der zweiten Schichtgitterkonstante liegt.

6. Halbleiterelement nach einem der vorhergehenden Ansprüche, **dadurch gekennzeichnet, dass** die erste Lage (12) und die zweite Lage (13), insbesondere um mindestens eine dezimale Größenordnung, dicker sind als die Schichten des Übergitters (23).

7. Halbleiterelement nach einem der vorhergehenden Ansprüche, **dadurch gekennzeichnet, dass** die Schichten Schichtdicken von weniger als einigen hundert Monolagen, insbesondere weniger als 100 und/oder weniger als 10 Monolagen, vorzugsweise weniger als eine Monolage, aufweisen.

8. Halbleiterelement nach einem der Ansprüche 4 bis 7, **dadurch gekennzeichnet, dass** das erste Schichtmaterial, das zweite Schichtmaterial und/oder das erste Lagenmaterial als ein binäres Material, vorzugsweise das erste Schichtmaterial als MgSe, das zweite Schichtmaterial als MgTe und das erste Lagenmaterial als ZnTe, ausgebildet ist.

9. Halbleiterelement nach einem der vorhergehenden Ansprüche, **gekennzeichnet durch** einen monolithischen Aufbau.

10. Bragg-Spiegel mit einer Anzahl von mehreren aufeinander aufgebrachten Halbleiterelementen nach einem der vorhergehenden Ansprüche.

11. Bragg-Spiegel nach Anspruch 10, **dadurch gekennzeichnet, dass** mittels einer geeigneten Auswahl der Anzahl der Schichtfolgen (24) im Übergitter (23) und/oder der Anzahl der Lagenpaare (11) eine Wellenlänge und/oder ein Wellenlängenbereich einer maximale Reflektivität, insbesondere im Bereich zwischen 550 nm und 750 nm, bestimmt ist.

12. Bragg-Spiegel nach Anspruch 10 oder 11, **dadurch gekennzeichnet, dass** mittels einer geeigneten Auswahl der Schichtdicke mindestens einer Schicht der Schichtfolge (24) und/oder der Lagendicke der ersten Lage (12) und/oder der zweiten Lage (13) des Lagenpaares (11) eine Wellenlänge und/oder ein Wellenlängenbereich einer maximalen Reflektivität, insbesondere im Bereich zwischen 550 nm und 750 nm, bestimmt ist.

13. Bragg-Spiegel nach einem der Ansprüche 10 bis 12, **dadurch gekennzeichnet, dass** sich die Lagendicke der ersten Lage (12) und zweiten Lage (13) mittels der Gleichung d = λ/(4n) ergibt, wobei d die Lagendicke, λ eine vorgegebene Wellenlänge und n der erste Brechungsindex für die erste Lage (12) oder der zweite Brechungsindex für die zweite Lage (13) ist.

14. Oberflächenemitter, insbesondere Vertikalresonator, Mikrokavität, Mikrosäule, mit einem Bragg-Spiegel (19) nach einem der Ansprüche 10 bis 13, wobei dieser insbesondere mindestens einen Quantenfilm und/oder Quantenpunkt aufweist und vorzugsweise der Quantenfilm und/oder Quantenpunkt aus einem optisch aktiven Medium, insbesondere ZnCdTe, ausgebildet ist, wobei das optisch aktive Medium vorzugsweise magnetische Anteile, insbesondere Mn-lonen, enthält.

15. Verwendung eines Halbleiterelementes (10) nach einem der Ansprüche 1 bis 9 und/oder eines Bragg-Spiegels (19) nach einem der Ansprüche 10 bis 13 und/oder eines Oberflächenemitters nach Anspruch 14 für eine Anwendung in der Optoelektronik, Quanteninformationsverarbeitung oder dergleichen.
